# EUROPEAN PATENT APPLICATION

(11) **EP 3 608 830 A1**
(43) Date of publication of application: **12.02.2020**
(21) Application number: 19169276.3
(22) Date of filing: 15.04.2019
(51) Int. Cl.: G06K 9/00, G06K 9/22, H02J 13/00

(54) **METHOD OF ACQUISITION OF STATE OF POWER SUPPLY DEVICE AND STATE ACQUISITION DEVICE FOR POWER SUPPLY DEVICE**

(30) Priority: 07.08.2018 JP 2018148431
(71) Applicant: OMRON Corporation, Shiokoji-dori, Shimogyo-ku Kyoto-shi Kyoto 600-8530 (JP)
(72) Inventor: NAGANO, Masaaki, Kyoto, 600-8530 (JP); TAKASHIMA, Yohei, Kyoto, 600-8530 (JP); TANINO, Kohei, Kyoto, 600-8530 (JP)
(74) Representative: Emde, Eric

(57) **Abstract**

A method of acquisition of a state of a power supply device and a device therefor which can improve convenience for a user are provided. A power supply device (100) includes a display part which displays a state of the inside or the surroundings thereof. A method of state acquisition by a state acquisition device (200) includes a step of acquiring an image of the power supply device (100) including at least the display part using a camera, a step of analyzing the image by a processing circuit to recognize a display state of the display part, and a step in which the processing circuit acquires information related to the state of the power supply device (100) on the basis of a predetermined relationship between the display state of the display part and the state of the power supply device.

## Description

### BACKGROUND

### Technical Field

The disclosure relates to a state acquisition method for a power supply device and a state acquisition device for a power supply device.

### Description of Related Art

In recent years, providing an explanation for the operation of electronic devices in the form of electronic data has been proposed. For example, Japanese Patent Laid-Open No. 2007-200094 (Patent Document 1) proposes a technology for alleviating the burden on a user before reaching a corresponding page when the user searches through an electronic manual for explaining the operation of an electronic device.

### [Literature Documents]

### [Patent Documents]

[Patent Document 1] Japanese Patent Laid-Open No. 2007-200094

### SUMMARY

In recent years, many electronic devices have come to be configured to notify a user of a state of the inside or the surroundings thereof by performing display using a monitor, a light emitting diode (LED), or the like. It is a burden on a user to have to refer to a manual in order to understand a state of an electronic device indicated by these displays.

Therefore, the disclosure provides a state acquisition method for a power supply device and a device therefor which can improve convenience for a user.

An example of the disclosure is a state acquisition method for a power supply device. The power supply device includes a display part which displays a state of the inside or the surroundings thereof. The state acquisition method includes a step of acquiring an image of the power supply device including at least the display part using a camera, a step of analyzing the image by a processing circuit to recognize a display state of the display part, and a step in which the processing circuit acquires information related to the state of the power supply device on the basis of a predetermined relationship between the display state of the display part and the state of the power supply device.

According to the above description, a user can ascertain a state of the power supply device through an operation for acquiring an image of the power supply device. Accordingly, it is possible to improve convenience for the user.

Preferably, the display part includes a lighting circuit. The predetermined relationship may be a relationship between a lighting state of the lighting circuit and the state of the power supply device.

According to the above description, the power supply device indicates a state thereof through the lighting state of the lighting circuit. By analyzing the lighting state of the lighting circuit, a state of the power supply device can be acquired.

Preferably, the lighting circuit displays a remaining amount of a service life of the power supply device. The step of acquiring this information includes a step of acquiring the remaining amount of the service life. The state acquisition method may further include a step of storing the acquired remaining amount of the service life in a storage device in association with a time at which the remaining amount of the service life is acquired, and a step of estimating a remaining service life of the power supply device from a plurality of pieces of information on the remaining amount of the service life stored in the storage device by the processing circuit.

According to the above description, the remaining service life of the power supply device can be estimated by acquiring the remaining amount of the service life of the power supply device a plurality of times.

Preferably, the power supply device includes identification information by which the power supply device is identified. The state acquisition method may further include a step of recognizing the identification information by the processing circuit and associating the information related to the state of the power supply device with the identification information.

According to the above description, for example, when each state of a plurality of power supply devices is acquired, information for each power supply device can be managed.

Preferably, the state acquisition method may further include a step of determining whether the power supply device is normal or abnormal by the processing circuit on the basis of the acquired information, and a step of displaying a message indicating an action to be taken for the power supply device on a display circuit when the power supply device is determined to be abnormal.

According to the above description, since an action to be taken for the power supply device can be indicated to the user, for example, the inconvenience for the user of referring to a manual can be reduced. Accordingly, it is possible to improve convenience for the user.

An example of the disclosure is a state acquisition device for a power supply device. The power supply device includes a display part which displays a state of the inside or the surroundings thereof. The state acquisition device includes a camera, and a processing circuit which analyzes an image acquired by the camera. The processing circuit recognizes a display state of the display part when the image acquired by the camera is an image of the power supply device including at least the display part and acquires information related to the state of the power supply device on the basis of a predetermined relationship between the recognized display state and the state of the power supply device.

According to the above description, the user can ascertain the state of the power supply device by operating the camera to acquire an image of the power supply device. Accordingly, it is possible to improve convenience for the user.

Preferably, the display part includes a lighting circuit. The predetermined relationship may be a relationship between a lighting state of the lighting circuit and the state of the power supply device.

According to the above description, the state acquisition device can acquire the state of the power supply device by analyzing the lighting state of the lighting circuit of the power supply device.

Preferably, the lighting circuit displays a remaining amount of a service life of the power supply device. The state acquisition device further includes a storage circuit. The processing circuit acquires the remaining amount of the service life, stores the acquired remaining amount of the service life in the storage circuit in association with a time at which the remaining amount of the service life is acquired, and estimates a remaining service life of the power supply device from a plurality of pieces of information on the remaining amount of the service life stored in the storage circuit.

According to the above description, the state acquisition device can estimate the remaining service life of the power supply device by acquiring the remaining amount of the remaining service life of the power supply device a plurality of times.

Preferably, the power supply device includes identification information by which the power supply device is identified. The processing circuit recognizes the identification information and associates the information related to the state of the power supply device with the identification information.

According to the above description, information for respective power supply devices can be managed, for example, when each state of a plurality of power supply devices is acquired.

Preferably, the state acquisition device further includes a display circuit. The processing circuit determines whether the power supply device is normal or abnormal on the basis of the acquired information. The processing circuit displays a message indicating an action to be taken for the power supply device on the display circuit when the power supply device is determined to be abnormal.

According to the above description, since an action to be taken for the power supply device can be indicated to the user, for example, the inconvenience for the user of referring to a manual can be reduced. Accordingly, it is possible to improve convenience for the user.

According to the disclosure, it is possible to provide a state acquisition method for a power supply device and a device therefor which can improve convenience for a user.

### BRIEF DESCRIPTION OF THE DRAWINGS

FIG. 1 is a configuration view of a system to which a state acquisition device for a power supply device is applied according to the present embodiment.
FIG. 2 is a schematic view for explaining an application example of the power supply device.
FIG. 3 is a view schematically illustrating an example of an external appearance of the power supply device.
FIG. 4 is a block diagram showing a configuration example of the power supply device according to the present embodiment.
FIG. 5 is a block diagram showing a configuration example of the state acquisition device.
FIG. 6 is a flowchart for explaining a state acquisition method for a power supply device of the state acquisition device.
FIG. 7 is a view schematically showing change in remaining service life.
FIG. 8 is a flowchart showing a process flow of estimating the remaining service life.
FIG. 9 is a view illustrating an example of display of the state acquisition device when a diagnosis result is normal.
FIG. 10 is a view illustrating a display example of the state acquisition device when a diagnosis result is abnormal.
FIG. 11 is a display example of the state acquisition device showing a first example of an action to be taken by a user.
FIG. 12 is a display example of the state acquisition device showing a second example of an action to be taken by the user.
FIG. 13 is a display example of the state acquisition device showing a third example of an action to be taken by the user.
FIG. 14 is a schematic view illustrating another example of a method of storing information of the state acquisition device.

### DESCRIPTION OF THE EMBODIMENTS

The embodiments will be described in detail below with reference to the drawings. Further, the same or corresponding portions in the drawings are denoted by the same reference signs.

### <Application example>

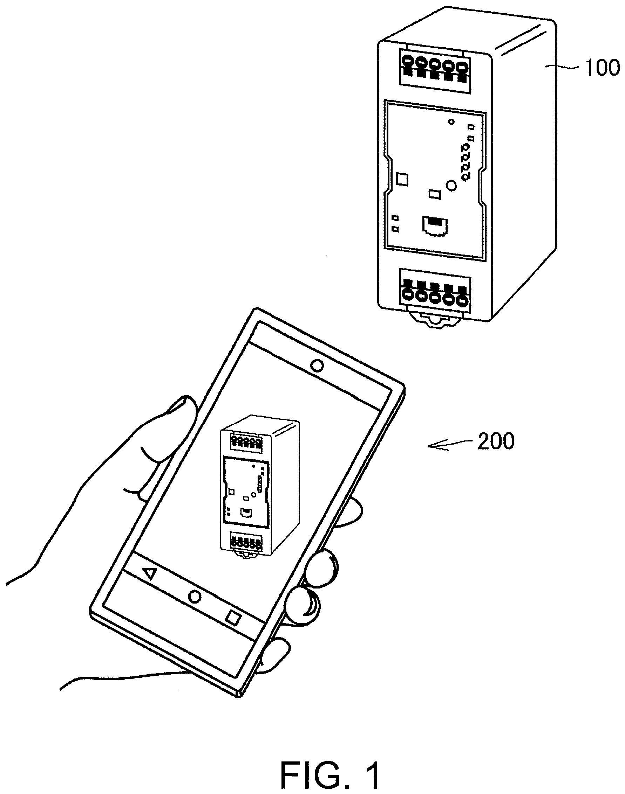

First, an example of a case to which the disclosure is applied will be described using FIG. 1. FIG. 1 is a configuration view of a system to which a state acquisition device 200 for a power supply device is applied according to the present embodiment. As illustrated in FIG. 1, the system includes a power supply device 100 and the state acquisition device 200 which acquires a state of the power supply device 100. The state acquisition device 200 may be realized by, for example, a smartphone.

The power supply device 100 is an electronic device whose state is acquired by the state acquisition device 200. A display circuit for displaying the state of the power supply device 100 is disposed on a front surface of the power supply device 100. The display circuit includes light emitting diode (LED).

In addition, a code indicating product identification information (for example, a bar code, or a two-dimensional code such as a QR code (registered trademark)) is disposed on the front surface of the power supply device 100. The state acquisition device 200 images the power supply device 100 to acquire an image of the power supply device 100 including the display circuit. The state acquisition device 200 analyzes the image of the power supply device 100 to recognize whether or not a lamp is turned on. Further, the state acquisition device 200 acquires product identification information of the power supply device 100 by reading the code disposed on the front surface of the power supply device 100. The state acquisition device 200 acquires the state of the power supply device 100 on the basis of a predetermined relationship between a state of the lamp (any one of turned-on, blinking, and turned-off) recognized by the state acquisition device 200 and the state of the power supply device 100. The state acquisition device 200 associates the information related to the state of the power supply device 100 with the product identification information. The information related to the state of the power supply device 100 and the product identification information are stored in the state acquisition device 200.

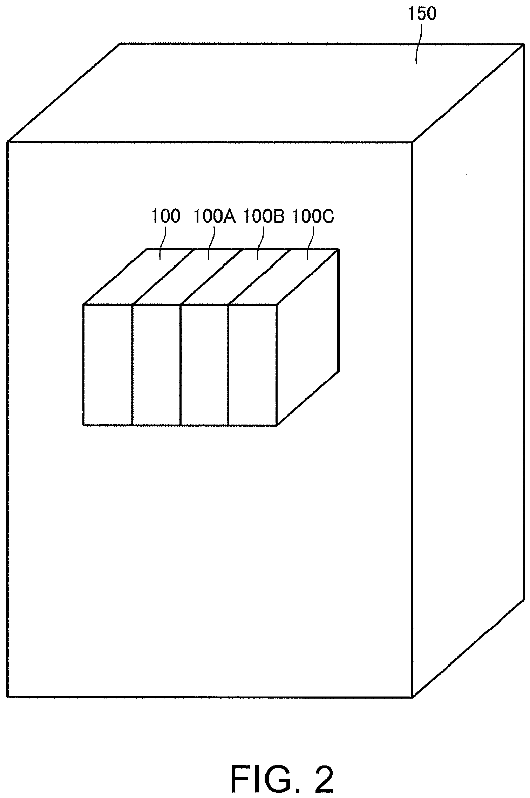

FIG. 2 is a schematic view for explaining an application example of the power supply device 100. The power supply device 100 may be installed, for example, on a control panel 300 in a production site. A plurality of power supply devices (power supply devices 100, 100A, 100B, and 100C are illustrated as an example) are disposed inside the control panel 300.

When each state of a plurality of power supply devices in the control panel 300 is checked and recorded on paper, as the number of power supply devices becomes larger, the work of checking and recording becomes a greater burden on a checker. According to the present embodiment, the checker need only acquire an image of each power supply device. The state acquisition device 200 can acquire a state of each power supply device and can store information related to the state. Accordingly, the burden of checking and recording the state of the power supply device can be alleviated for the checker.

Further, a state of each power supply device 100 can be checked at time intervals by the state acquisition device 200. Thereby, the checker can observe a progression of the states of each power supply device.

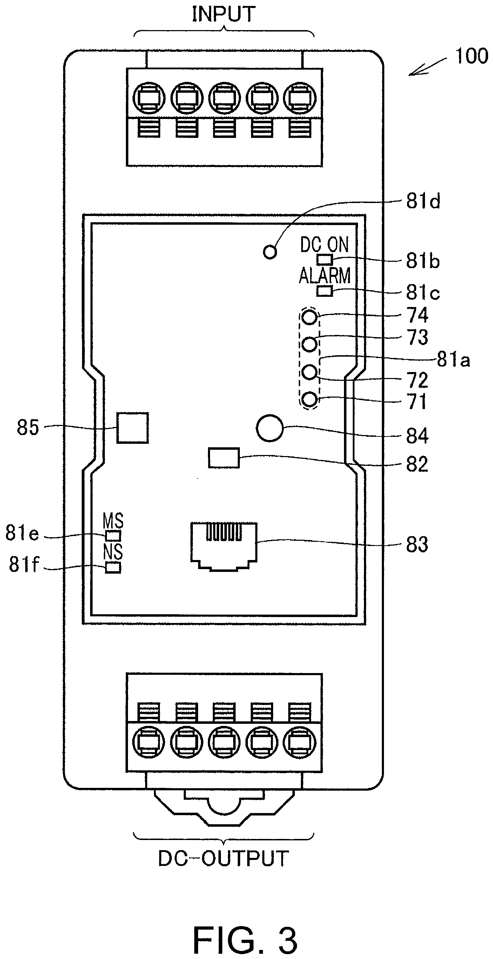

FIG. 3 is a view schematically illustrating an example of an external appearance of the power supply device 100. As illustrated in FIG. 3, in the power supply device 100, display circuits 81a to 81f, a display switch/reset key 82, a communication port 83, an output voltage regulating trimmer 84, and a two-dimensional code 85 are disposed on a surface on which an INPUT terminal and a DC-OUTPUT terminal are provided. Further, the disposition illustrated in FIG. 3 is an example.

The display circuit 81a includes LEDs 71 to 74 and can change the number of turned-on LEDs among the plurality of LEDs. Alternatively, the display circuit 81a may include LEDs of which emission colors can be made different.

The LEDs 71 to 74 indicate a state related to the power supply device 100. For example, the "state related to the power supply device 100" can include an ambient temperature of the power supply device 100, an output current of the power supply device 100, an output voltage of the power supply device 100, a remaining service life (a remaining amount of the service life) of the power supply device 100, and an operation time of the power supply device 100. In one embodiment, the display circuit 81a transmits these states to the state acquisition device by causing the LEDs to blink according to a specific blinking pattern.

Each of display circuits 81b, 81c, and 81d also includes an LED. Each of the display circuits 81b, 81c, and 81d can also display a state related to the power supply device 100. For example, when an input voltage is input normally to a power supply unit of the power supply device 100, an LED of the display circuit 81d may be turned on. When a direct current (DC) voltage is output from the power supply device 100, an LED of the display circuit 81b may be turned on. On the other hand, when an abnormality occurs inside the power supply device 100, an LED of the display circuit 81c may be turned on. The display circuit 81e and the display circuit 81f include respective LEDs. When these LEDs are turned on, a communication state (including a block state MS and a network state NS) at the communication port 83 is indicated. The LED of each of the display circuits described above corresponds to a "lighting circuit" included in the state acquisition device according to the present embodiment.

The display switch/reset key 82 is operated to switch a parameter to be displayed. Alternatively, the display switch/reset key 82 may be operated to reset communication settings. The output voltage regulating trimmer 84 is operated to regulate an output voltage.

The two-dimensional code 85 is a code indicating product identification information. Types of product identification information are not particularly limited as long as the information allows each power supply device to be uniquely identified from the plurality of power supply devices 100 (see FIG. 2). For example, a serial number of a product may be used as the product identification information.

### <Configuration example of power supply device>

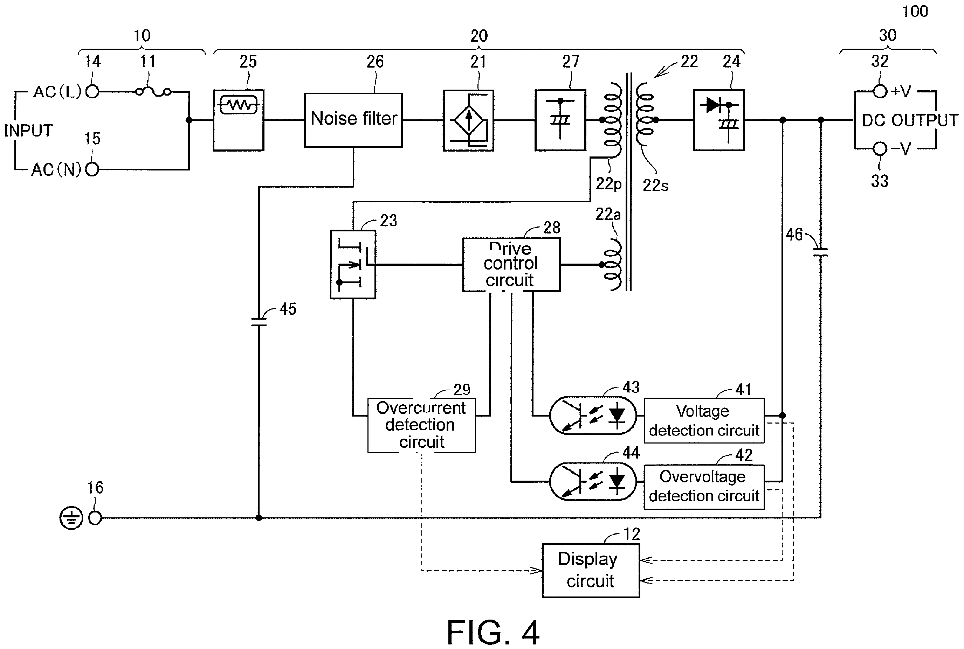

FIG. 4 is a block diagram showing a configuration example of the power supply device 100 according to the present embodiment. As shown in FIG. 4, the power supply device 100 includes an input unit 10 that receives an input voltage from the outside, a power supply unit 20, and an output unit 30.

For example, the input unit 10 is connected to an alternating current (AC) power supply (not shown) (for example, a commercial power supply of 50 Hz/60 Hz, 100 V/200 V). The input unit 10 includes input terminals 14 and 15 (also denoted by an "INPUT"), a fuse 11 which is a protection circuit connected to the input terminal 14, and a protective ground terminal 16.

The power supply unit 20 generates a power supply voltage from the voltage input through the input unit 10. As an example, the power supply unit 20 may include a rectifying circuit 21, a transformer 22, a metal oxide semiconductor field effect transistor (MOSFET) 23 as a switching element, and a rectifying/smoothing circuit 24. Further, the power supply unit 20 includes an inrush current limiting circuit 25, a noise filter 26, a smoothing circuit 27, a drive control circuit 28, an overcurrent detection circuit 29, a voltage detection circuit 41, an overvoltage detection circuit 42, a photocoupler 43, a photocoupler 44, and capacitors 45 and 46.

The inrush current limiting circuit 25 may be constituted by, for example, a resistor and a relay inserted into the resistor in parallel. The relay opens for tens of milliseconds from the time of starting to prevent an inrush current. Thereafter, the relay is closed and the power supply device 100 starts to operate.

The noise filter 26 performs filtering on high frequency noise components superimposed on an AC voltage input to the INPUT and supplies the AC voltage from which the noise components are removed to the rectifying circuit 21. The smoothing circuit 27 is constituted by a smoothing capacitor and smoothes the voltage after full-wave rectification.

The transformer 22 includes a primary winding 22p, a secondary winding 22s, and an auxiliary winding 22a, and induces a high-frequency pulse voltage generated in the primary winding 22p to the secondary winding 22s and the auxiliary winding 22a. The high-frequency pulse voltage induced in the secondary winding 22s is used for a DC output. The high-frequency pulse voltage induced in the auxiliary winding 22a is used for starting an operation of the drive control circuit 28.

The rectifying/smoothing circuit 24 is constituted by a rectifying circuit and a smoothing capacitor, rectifies and smoothes a high-frequency pulse power supply (AC power supply) induced in the secondary winding 22s of the transformer 22, and generates a DC output having a specified output voltage and output current.

The voltage detection circuit 41 detects the output voltage of the DC output power supply with a corresponding step-down voltage. The photocoupler 43 outputs a signal corresponding to the detected step-down voltage to the drive control circuit 28. The overvoltage detection circuit 42 detects an overvoltage when the output voltage of the DC output power supply exceeds the specified voltage. The photocoupler 44 outputs a signal indicating the detection of the overvoltage to the drive control circuit 28.

The drive control circuit 28 is configured as a control integrated circuit (IC) including a pulse width modulation (PWM) signal generator, a feedback control circuit, an overcurrent protect (OCP) terminal, a switching drive terminal, a driving power supply terminal, and the like. The drive control circuit 28 supplies a PWM signal to a gate of the MOSFET 23 to drive the MOSFET 23.

A secondary side voltage detected by the voltage detection circuit 41 returns to the drive control circuit 28 via the photocoupler 43. The drive control circuit 28 changes a duty ratio of the PWM signal on the basis of the voltage and drives the MOSFET 23 so that the power supply voltage serving as the output voltage becomes the specified voltage.

The MOSFET 23 is connected in series to the primary winding 22p of the transformer 22. The MOSFET 23 connects or disconnects the primary side voltage in response to the PWM signal supplied from the drive control circuit 28 and causes the primary winding 22p of the transformer 22 to generate a high-frequency pulse power supply.

The output unit 30 includes output terminals 32 and 33. The power supply voltage generated in the power supply unit 20 is output from the output terminals 32 and 33 (also denoted by a "DC OUTPUT"). Further, in the configuration shown in FIG. 4, a DC voltage is output as the power supply voltage.

The power supply device 100 further includes a display circuit 12. The display circuit 12 includes the display circuits 81a to 81f as illustrated in FIG. 3. The display circuit 12 turns on, turns off, or blinks corresponding LEDs in response to respective signals from, for example, the voltage detection circuit 41, the overvoltage detection circuit 42, and the overcurrent detection circuit 29.

### <Configuration example of state acquisition device>

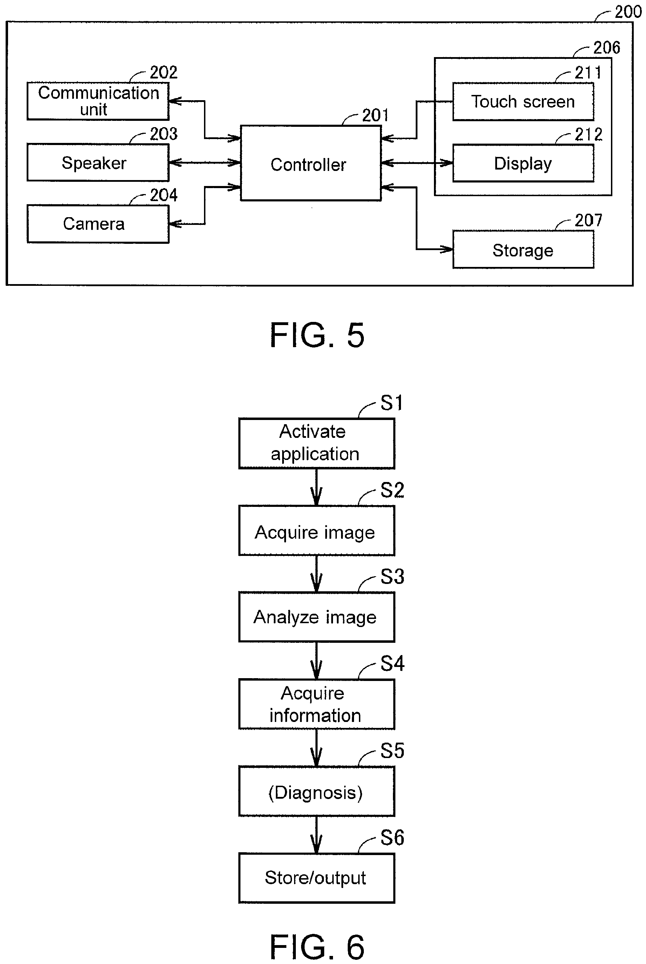

FIG. 5 is a block diagram showing a configuration example of the state acquisition device 200. The state acquisition device 200 is an information communication terminal having a camera. The information communication terminal realizes the state acquisition device 200 by executing an application program for acquiring a state of the power supply device 100.

The state acquisition device 200 can be realized by, for example, a smartphone. However, the state acquisition device 200 can also be realized by another information terminal such as a tablet, a laptop personal computer (PC), or the like.

The state acquisition device 200 includes a controller 201, a communication unit 202, a speaker 203, a camera 204, a sensor (not shown), a display unit 206, and a storage 207. The controller 201 controls the whole of the state acquisition device 200. Further, the controller 201 executes an application program for acquiring the state of the power supply device 100. The controller 201 corresponds to a processing circuit in the state acquisition device according to the present embodiment.

The communication unit 202 is a circuit for connecting the state acquisition device 200 to a communication network for communication therebetween. The speaker 203 outputs sound according to the control of the controller 201. The camera 204 images the power supply device 100.

The display unit 206 includes a touch screen 211 and a display 212. The touch screen 211 is an input unit that receives an input for operating the state acquisition device 200 from a user. The display 212 displays the image of the power supply device 100 captured by the camera 204 and displays results of various types of processing of the controller 201. The display 212 corresponds to the display circuit in the state acquisition device according to the present embodiment.

The storage 207 corresponds to a storage circuit in the state acquisition device according to the present embodiment. The storage 207 stores an application program for acquiring the state of the power supply device 100 and data of various types. The information stored in the storage 207 is read by the controller 201 and used for processing by the controller 201. The information related to the state of the power supply device 100 and the product identification information are stored in the storage 207 in association with each other. The storage 207 further stores results of processing of the controller 201.

FIG. 6 is a flowchart for explaining a state acquisition method for a power supply device 100 using the state acquisition device 200. In step S1, when the user operates the state acquisition device 200, the application program for acquiring a state of the power supply device 100 is read from the storage 207 by the controller 201. The controller 201 activates the application.

In step S2, the camera 204 acquires the image of the power supply device 100 through an operation of the user. At this time, the camera 204 acquires the image of the power supply device 100 including the display circuits 81a to 81f (see FIG. 3) of the power supply device 100 through an operation of the user.

In step S3, the controller 201 analyzes the image captured by the camera 204. In step S4, the controller 201 acquires information related to the state of the power supply device 100, for example, from the analyzed image. Specifically, the controller 201 analyzes the image of the power supply device 100 to recognize a lighting state of an LED included in each of the display circuits 81a to 81d. The controller 201 recognizes whether an LED of each display circuit is turned on or turned off. Further, a plurality of images may be acquired by the camera 204 capturing images at predetermined time intervals. In this case, the controller 201 can recognize whether a state of the LED of each display circuit is in a turned-on, turned-off, or blinking state.

The display states of the display circuits 81a to 81d (turned-on, turned-off, or blinking of the LED) indicate the state of the power supply device 100. The storage 207 stores information related to a predetermined relationship between the display state of the display circuits 81a to 81d and the state of the power supply device 100. The controller 201 acquires the state of the power supply device 100 on the basis of the information on the predetermined relationship and the state of the LED of each display circuit. Further, various known methods can be applied to the image analysis and information extraction.

In step S5, the controller 201 executes diagnosis of the state of the power supply device 100 on the basis of the acquired information. However, the processing of step S5 may be omitted. In step S6, the controller 201 stores the information related to the state of the power supply device 100 in the storage 207. At this time, the controller 201 recognizes the identification information of the power supply device 100 by reading the two-dimensional code 85 and associates the information related to the state of the power supply device 100 with the identification information. Further, the controller 201 stores the information related to the state of the power supply device 100 in the storage 207 in association with the identification information of the power supply device 100. When the diagnosis of the state of the power supply device 100 is executed in step S5, the controller 201 stores the result of the diagnosis in the storage 207.

### <Example of state acquisition function>

Some specific examples of a state acquisition function and a diagnosis function of the state acquisition device 200 will be described below. A first example is a function of acquiring information displayed on the display circuit 81a of the power supply device 100. The display circuit 81a can transmit these states to the state acquisition device 200 by blinking at least one of the LEDs 71 to 74 according to a specific blinking pattern. The display circuit 81a can display the state of the power supply device 100 according to a blinking interval or a predetermined blinking method.

The display circuit 81a can display temperature information with the LEDs 71 to 74. The "temperature information" may be information on internal temperature of the power supply device 100 or information on ambient temperature of the power supply device 100. Since the power supply device 100 ascertains an amount of output power of the power supply device 100, the power supply device 100 can ascertain an amount of self-heat generation. Therefore, the power supply device 100 can predict the ambient temperature.

A second example is a function of acquiring a remaining service life of the power supply device 100. The display circuit 81a can display the remaining service life with the LEDs 71 to 74. The state acquisition device 200 acquires information related to the remaining service life by imaging the power supply device 100. At this time, the state acquisition device 200 associates the remaining service life with a time at which the remaining service life is acquired. Then, the controller 201 of the state acquisition device 200 stores the remaining service life and the acquisition time in the storage 207.

The information related to the remaining service life is acquired a plurality of times. The storage 207 stores a plurality of pieces of information on the remaining service life. The controller 201 reads the information on the remaining service life stored in the storage 207 and estimates the remaining service life of the power supply device 100 on the basis of the read information.

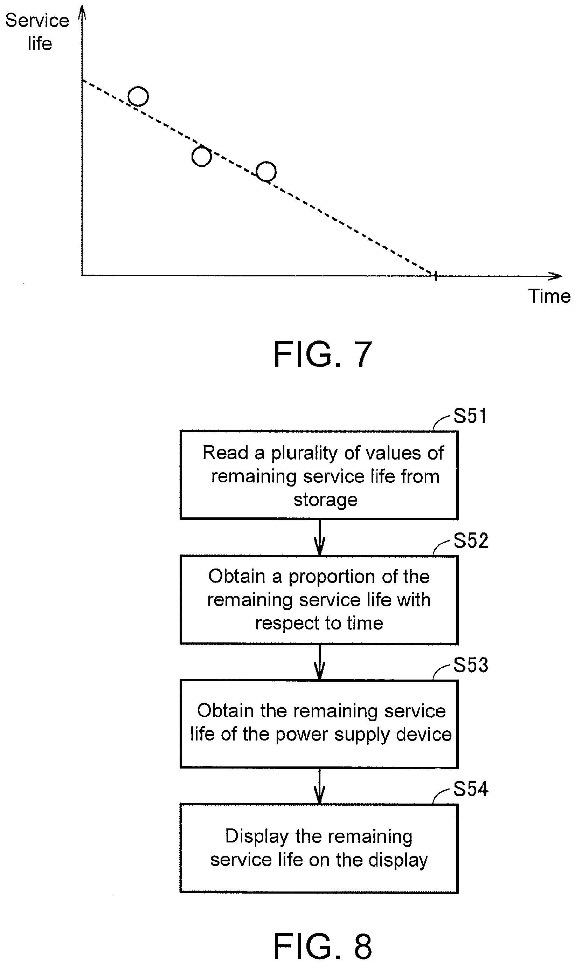

FIG. 7 is a view schematically showing change in the remaining service life. FIG. 8 is a flowchart showing a process flow of estimating the remaining service life. The flow shown in FIG. 8 can be executed in step S5 (see FIG. 6), for example. As shown in FIGS. 7 and 8, the controller 201 reads a plurality of values of the remaining service life from the storage 207 (step S51). The controller 201 applies a linear approximation to the plurality of values of remaining service lives to obtain a proportion (inclination of a straight line) of the remaining service life with respect to the time (step S52). From the inclination of the straight line, the controller 201 obtains the remaining service life (remaining time until the power supply device 100 reaches the end of the service life) of the power supply device 100 (step S53). Then, the controller 201 displays the remaining service life on the display unit 206 (step S54).

A third example is a function of diagnosing whether or not the power supply device 100 is normal. The state acquisition device 200 acquires information related to a lighting state of each LED of the display circuits 81a to 81f. On the basis of the information, the state acquisition device 200 diagnoses whether or not the power supply device 100 is normal. The state acquisition device 200 stores a diagnosis result thereof in the storage 207 and displays the diagnosis result on the display unit 206 (display 212).

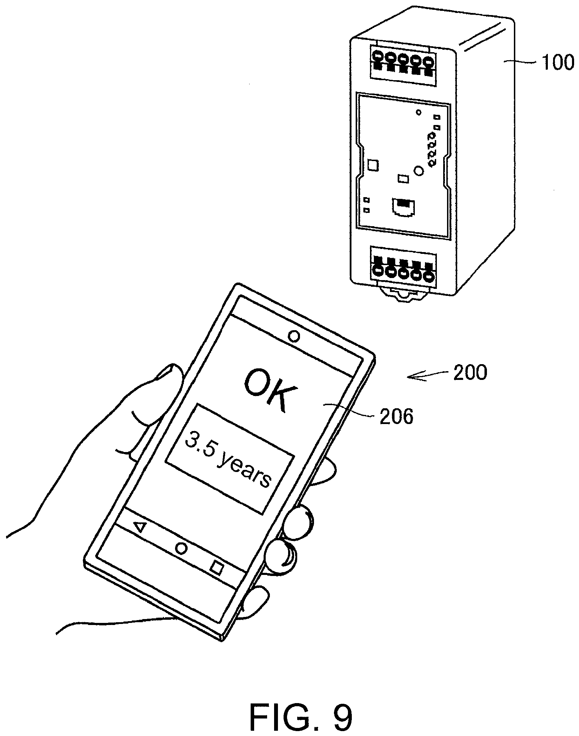

FIG. 9 is a view illustrating a display example of the state acquisition device 200 when the diagnosis result is normal. As illustrated in FIG. 9, a value of the remaining service life (3.5 years) as well as a message "OK" is displayed on the display unit 206.

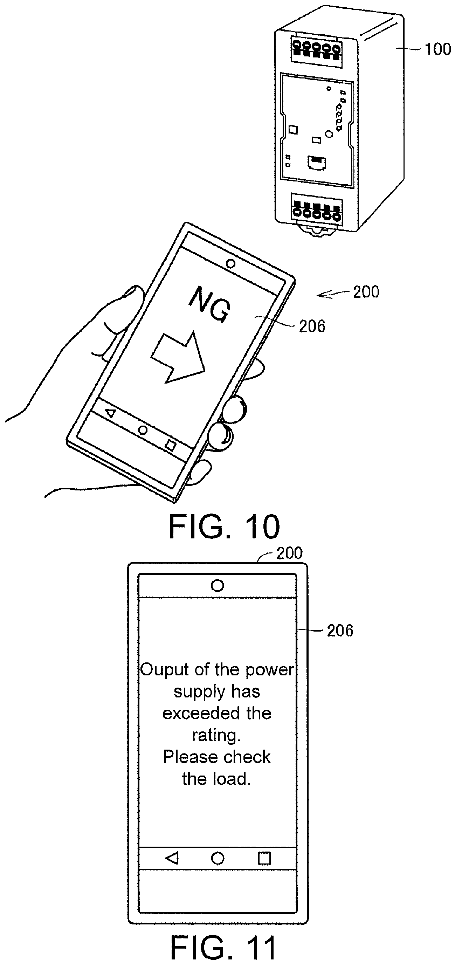

FIG. 10 is a view illustrating a display example of the state acquisition device 200 when the diagnosis result is abnormal. As illustrated in FIG. 10, a message "NG" is displayed on the display unit 206 and an arrow is displayed. The user of the state acquisition device 200 operates the display unit 206 according to the arrow. Thereby, a message indicating an action (action to be taken by the user) for the state acquisition device 200 is displayed on the display unit 206.

FIG. 11 is a display example of the state acquisition device 200 showing a first example of an action to be taken by the user. When an output of the power supply device 100 exceeds a rating thereof, a notification "Output of the power supply has exceeded the rating" and a message "Please check the load" are displayed.

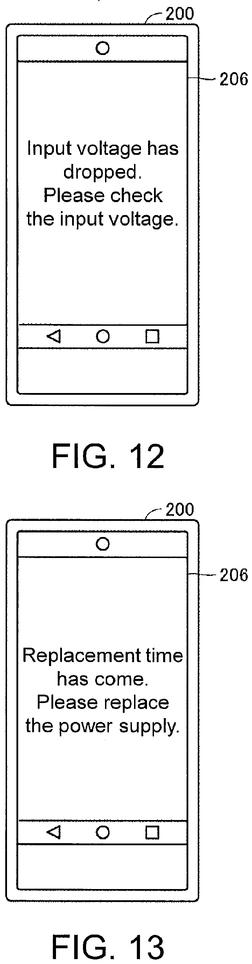

FIG. 12 is a display example of the state acquisition device 200 showing a second example of an action to be taken by the user. When an input voltage of the power supply device 100 drops, a notification "Input voltage has dropped" and a message "Please check the input voltage" are displayed.

FIG. 13 is a display example of the state acquisition device 200 showing a third example of an action to be taken by the user. When the power supply device 100 has reached the end of the service life or approaches the end of the service life, a notification "Replacement time has come" and a message "Please replace the power supply" are displayed.

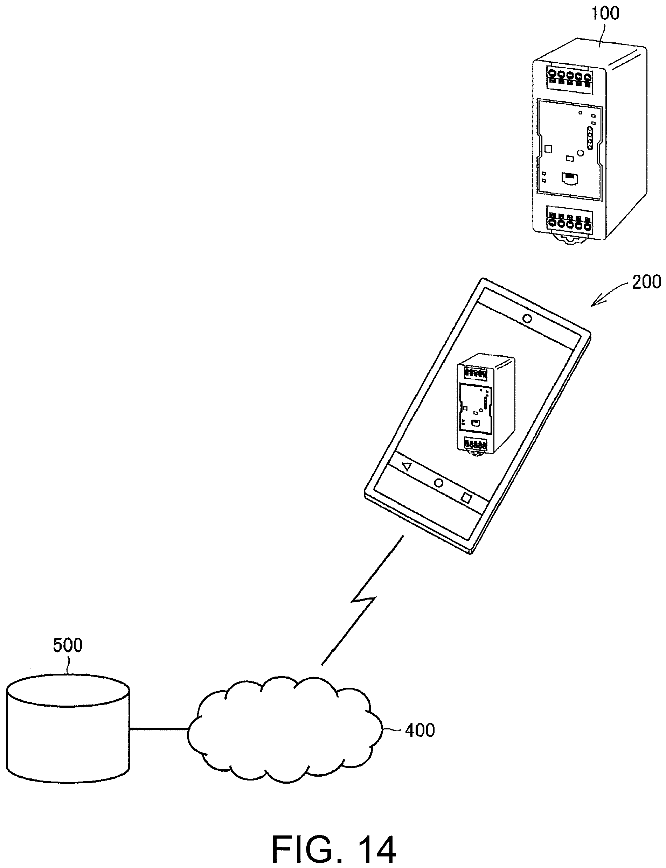

Also, in the above description, the state acquisition device 200 stores the information acquired from the power supply device 100 in the state acquisition device 200. However, the state acquisition device 200 may store the information acquired from the power supply device 100 in a server external to the state acquisition device 200. FIG. 14 is a schematic view illustrating another example of a method of storing information of the state acquisition device 200. As illustrated in FIG. 14, the state acquisition device 200 may store information in a server 500 via a network 400. Further, the state acquisition device 200 may read information from the server 500 via the network 400. For example, information on a proportion until a replacement time of the power supply device 100 is stored in the server 500. In order to estimate the remaining service life, the state acquisition device 200 can read the information on the proportion until the replacement time and information on a time associated with the information from the server 500 via the network 400.

### <Additional statement>

As described above, the present embodiment includes the following disclosure.

### (Configuration 1)

A state acquisition method for a power supply device (100), in which the power supply device (100) includes a display part (81a to 81f) which displays a state of an inside or surroundings thereof, the state acquisition method including
a step (S2) of acquiring an image of the power supply device (100) including at least the display part (81a to 81f) using a camera (204),
a step (S3) of analyzing the image by a processing circuit (201) to recognize a display state of the display part (81a to 81f), and
a step (S4) in which the processing circuit (201) acquires information related to the state of the power supply device (100) on the basis of a predetermined relationship between the display state of the display part (81a to 81f) and the state of the power supply device (100).

### (Configuration 2)

The state acquisition method for a power supply device (100) according to Configuration 1, in which
the display parts (81a to 81f) includes a lighting circuit, and
the predetermined relationship is a relationship between a lighting state of the lighting circuit and the state of the power supply device (100).

### (Configuration 3)

The state acquisition method for a power supply device (100) according to the Configuration 2, in which the lighting circuit displays a remaining amount of a service life of the power supply device (100), and the step of acquiring the information includes a step of acquiring the remaining amount of the service life, the state acquisition method further including
a step (S6) of storing the acquired remaining amount of the service life in a storage device in association with a time at which the remaining amount of the service life is acquired, and
steps (S51 to S53) of estimating a remaining service life of the power supply device (100) from a plurality of pieces of information on the remaining amount of the service life stored in the storage device by the processing circuit (201).

### (Configuration 4)

The state acquisition method for a power supply device (100) according to any one of Configurations 1 to 3, in which the power supply device (100) includes identification information (85) by which the power supply device (100) is identified, the state acquisition method further including
a step (S6) of recognizing the identification information by the processing circuit (201) and associating the information related to the state of the power supply device (100) with the identification information (85).

### (Configuration 5)

The state acquisition method for a power supply device (100) according to any one of Configurations 1 to 4, further including
a step (S5) of determining whether the power supply device (100) is normal or abnormal by the processing circuit (201) on the basis of the acquired information, and
a step of displaying a message indicating an action to be taken for the power supply device (100) on a display unit (206) when the power supply device (100) is determined to be abnormal.

### (Configuration 6)

A state acquisition device for a power supply device (100), in which the power supply device (100) includes a display part (81a to 81f) which displays a state of an inside or surroundings thereof, the state acquisition device including
a camera (204), and
a processing circuit (201) which analyzes an image acquired by the camera (204), in which
the processing circuit recognizes a display state of the display part (81a to 81f) when the image acquired by the camera (204) is an image of the power supply device (100) including at least the display part (81a to 81f) and acquires information related to the state of the power supply device (100) on the basis of a predetermined relationship between the recognized display state and the state of the power supply device (100).

### (Configuration 7)

The state acquisition device for the power supply device (100) according to Configuration 6, in which
the display part (81a to 81f) includes a lighting circuit, and
the predetermined relationship is a relationship between a lighting state of the lighting circuit and the state of the power supply device (100).

### (Configuration 8)

The state acquisition device for the power supply device (100) according to Configuration 7, in which the lighting circuit displays a remaining amount of a service life of the power supply device (100), the state acquisition device further including a storage circuit (207), in which
the processing circuit (201) acquires the remaining amount of the service life, stores the acquired remaining amount of the service life in the storage circuit (207) in association with a time at which the remaining amount of the service life is acquired, and estimates a remaining service life of the power supply device (100) from a plurality of pieces of information on the remaining amount of the service life stored in the storage circuit (207).

### (Configuration 9)

The state acquisition device for the power supply device (100) according to any one of Configurations 6 to 8, in which
the power supply device (100) includes identification information (85) by which the power supply device (100) is identified, and
the processing circuit recognizes the identification information (85) and associates the information related to the state of the power supply device (100) with the identification information (85).

### (Configuration 10)

The state acquisition device for the power supply device (100) according to any one of Configurations 6 to 9, further including a display unit (206), in which
the processing circuit (201) determines whether the power supply device (100) is normal or abnormal on the basis of the acquired information, and
the processing circuit (201) displays a message indicating an action to be taken for the power supply device (100) on the display unit (206) when the power supply device (100) is determined to be abnormal.

Further, the present embodiment includes the following disclosure.

### (Configuration 11)

A power supply device (100) including
an input unit (10) which receives an input voltage from the outside,
a power supply unit (20) which generates a power supply voltage from the input voltage input through the input unit (10),
an output unit (30) which outputs the power supply voltage, and
a display circuit (12) which displays a state of the power supply device (100), in which
the display circuit (12) includes a lighting circuit, and
the lighting circuit is turned on in a pattern corresponding to the state of the power supply device (100).

### (Configuration 12)

A system including a power supply device (100), in which the power supply device (100) includes a display part (81a to 81f) which displays a state of an inside or surroundings thereof, and further including a state acquisition device which acquires a state of the power supply device (100), in which
the state acquisition device includes
a camera (204), and
a processing circuit (201) which analyzes an image acquired by the camera (204), in which
the processing circuit extracts features related to the display part (81a to 81f) from the image when the image acquired by the camera (204) is an image of the power supply device (100) including at least the display part (81a to 81f) and acquires information related to the state of the power supply device (100) on the basis of a predetermined relationship between the extracted features and the state of the power supply device (100).

### [Reference Signs List]

10 Input unit
11 Fuse
12, 81a to 81f Display circuit
14, 15 Input terminal
16 Protective ground terminal
20 Power supply unit
21 Rectifying circuit
22 Transformer
22a Auxiliary winding
22p Primary winding
22s Secondary winding
23 MOSFET
24, 27 Smoothing circuit
25 Inrush current limiting circuit
26 Noise filter
28 Drive control circuit
29 Overcurrent detection circuit
30 Output unit
32, 33 Output terminal
41 Voltage detection circuit
42 Overvoltage detection circuit
43, 44 Photocoupler
45, 46 Capacitor
82 Display switch/reset key
83 Communication port
84 Output voltage regulating trimmer
85 Two-dimensional code
100, 100A to 100C Power supply device
200 State acquisition device
201 Controller
202 Communication unit
203 Speaker
204 Camera
206 Display unit
207 Storage
211 Touch screen
212 Display
300 Control panel
400 Network
500 Server
S1 to S6, S51 to S54 Step

## Claims

1. A state acquisition method for a power supply device (100), in which the power supply device (100) includes a display part (81a to 81f) which displays a state of an inside or surroundings thereof, **characterized in that**, the state acquisition method comprises:
a step (S2) of acquiring an image of the power supply device (100) including at least the display part (81a to 81f) using a camera (204);
a step (S3) of analyzing the image by a processing circuit (201) to recognize a display state of the display part; and
a step (S4) in which the processing circuit (201) acquires information related to the state of the power supply device (100) on the basis of a predetermined relationship between the display state of the display part (81a to 81f) and the state of the power supply device (100).

2. The state acquisition method for the power supply device (100) according to claim 1, wherein
the display part (81a to 81f) comprises a lighting circuit, and
the predetermined relationship is a relationship between a lighting state of the lighting circuit and the state of the power supply device (100).

3. The state acquisition method for the power supply device (100) according to the claim 2, in which the lighting circuit displays a remaining amount of a service life of the power supply device (100), and the step of acquiring the information comprises a step of acquiring the remaining amount of the service life, the state acquisition method further comprising:
a step (S6) of storing the acquired remaining amount of the service life in a storage device in association with a time at which the remaining amount of the service life is acquired; and
a step (S51 to S53) of estimating a remaining service life of the power supply device (100) by the processing circuit (201) from a plurality of pieces of information on the remaining amount of the service life stored in the storage device.

4. The state acquisition method for the power supply device (100) according to any one of claims 1 to 3, in which the power supply device (100) comprises identification information by which the power supply device (100) is identified, the state acquisition method further comprising:
a step (S6) of recognizing the identification information by the processing circuit (201) and associating the information related to the state of the power supply device (100) with the identification information.

5. The state acquisition method for the power supply device (100) according to any one of claims 1 to 4, further comprising:
a step (S5) of determining whether the power supply device (100) is normal or abnormal by the processing circuit (201) on the basis of the acquired information; and
a step of displaying a message indicating an action to be taken for the power supply device (100) on a display unit when the power supply device (100) is determined to be abnormal.

6. A state acquisition device (200) for a power supply device (100), in which the power supply device (100) includes a display part (81a to 81f) which displays a state of an inside or surroundings thereof, **characterized in that**, the state acquisition device comprises:
a camera (204); and
a processing circuit (201) which analyzes an image acquired by the camera (204), wherein
the processing circuit (201) recognizes a display state of the display part (81a to 81f) when the image acquired by the camera (204) is an image of the power supply device (100) including at least the display part (81a to 81f) and acquires information related to the state of the power supply device (100) on the basis of a predetermined relationship between the recognized display state and the state of the power supply device (100).

7. The state acquisition device for the power supply device (100) according to claim 6, wherein
the display part (81a to 81f) comprises a lighting circuit, and
the predetermined relationship is a relationship between a lighting state of the lighting circuit and the state of the power supply device (100).

8. The state acquisition device for the power supply device (100) according to claim 7, in which the lighting circuit displays a remaining amount of a service life of the power supply device (100), the state acquisition device further comprising a storage circuit, wherein
the processing circuit (201) acquires the remaining amount of the service life, stores the acquired remaining amount of the service life in the storage circuit in association with a time at which the remaining amount of the service life is acquired, and estimates a remaining service life of the power supply device (100) from a plurality of pieces of information on the remaining amount of the service life stored in the storage circuit.

9. The state acquisition device for the power supply device (100) according to any one of claims 6 to 8, wherein
the power supply device (100) comprises identification information by which the power supply device (100) is identified, and
the processing circuit (201) recognizes the identification information and associates the information related to the state of the power supply device (100) with the identification information.

10. The state acquisition device for the power supply device (100) according to any one of claims 6 to 9, further comprising a display circuit, wherein
the processing circuit (201) determines whether the power supply device (100) is normal or abnormal on the basis of the acquired information, and
the processing circuit (201) displays a message indicating an action to be taken for the power supply device (100) on the display circuit when the power supply device (100) is determined to be abnormal.
